# FASCICULE DE BREVET EUROPEEN

(11) **EP 4 062 447 B1**
(45) Date de publication et mention de la délivrance du brevet: **17.04.2024**
(21) Numéro de dépôt: 20861958.5
(22) Date de dépôt: 12.11.2020
(51) Int. Cl.: H01L 23/495

(54) **CADRE METALLIQUE CONDUCTEUR POUR MODULE ÉLECTRONIQUE DE PUISSANCE ET PROCEDE DE FABRICATION ASSOCIE**
METALLISCHER LEITENDER RAHMEN FÜR ELEKTRONISCHES LEISTUNGMODUL UND ZUGEHÖRIGES HERSTELLUNGSVERFAHREN
METALLIC CONDUCTIVE FRAME FOR ELECTRONIC POWER MODULE AND RELATED MANUFACTURING METHOD

(30) Priorité: 19.11.2019 FR 1912900
(43) Date de publication de la demande: 28.09.2022
(73) Titulaire: SAFRAN, 75015 Paris (FR); SAFRAN ELECTRONICS & DEFENSE, 92100 Boulogne Billancourt (FR)
(72) Inventeur: YOUSSEF, Toni, 77550 MOISSY-CRAMAYEL (FR); AZZOPARDI, Stéphane, Joseph, 77550 MOISSY-CRAMAYEL (FR); LE, Thanh Long, 77550 MOISSY-CRAMAYEL (FR); RIOU, Jean-Christophe, 77550 MOISSY-CRAMAYEL (FR); SRIDI-CONVERS, Nawres, 77550 MOISSY-CRAMAYEL (FR)
(74) Mandataire: Cabinet Beau de Loménie
(86) Numéro de dépôt international: PCT/FR2020/052066
(87) Numéro de publication internationale: WO 2021/099719

(56) Documents cités:
- EP-A1- 0 954 210
- US-A1- 2008 024 995
- US-A1- 2011 286 179

## Description

### Domaine Technique

La présente invention se rapporte au domaine général de la conversion d'énergie notamment dans le domaine aéronautique où les contraintes thermiques et les contraintes de masse et de volume peuvent être sévères et elle concerne plus particulièrement un cadre métallique conducteur (« leadframe ») de modules électroniques de puissance intégrant des convertisseurs et nécessaires à l'électrification des systèmes propulsifs et non propulsifs à bord des aéronefs, afin de convertir l'énergie électrique du réseau principal (115V AC, 230V AC, 540V DC...) sous différentes formes appropriées (AC/DC, DC/AC, AC/AC et DC/DC).

### Technique antérieure

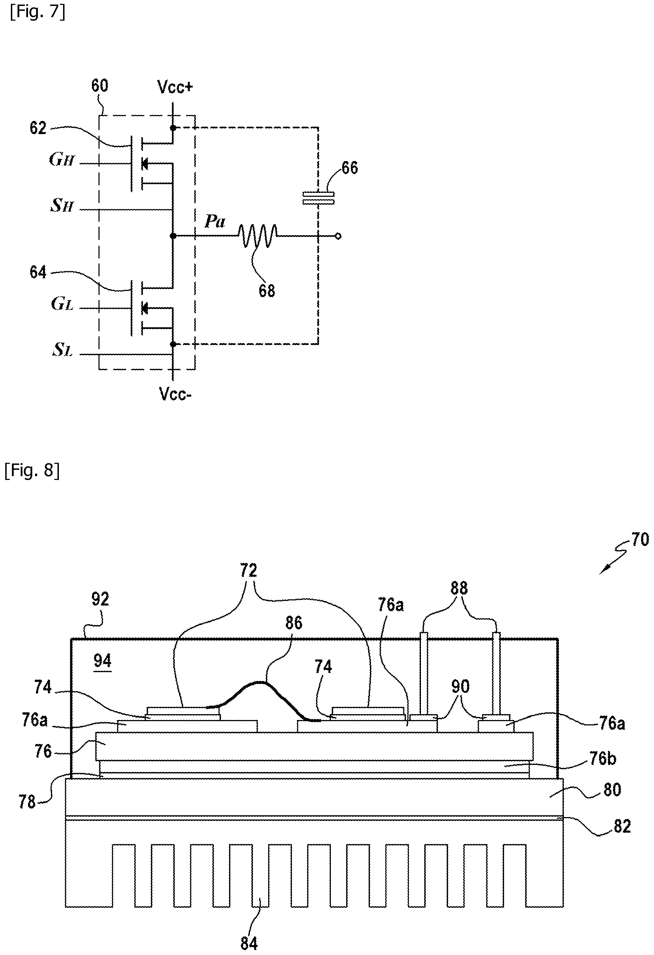

La figure 7 montre un étage de puissance à semi-conducteurs conventionnel 60 comportant deux transistors de type MOSFET 62, 64 montés en série entre les tensions d'alimentation Vcc+ et Vcc-. Un tel étage auquel peut être associé extérieurement un condensateur de découplage 66 et un shunt de courant 68, est classiquement réalisé sous la forme du module électronique de puissance conventionnel dont la superposition de couches de différents matériaux formant ce module 70 est illustré de façon schématique à la figure 8, et comportant :
. des premier et second composants semi-conducteurs de puissance 72 (source de chaleur),
. une première interface d'interconnexion métallique 74 (joint brasé ou fritté, colle chargée) pour reporter le composant semi-conducteur de puissance sur un substrat,
. un substrat généralement constitué d'une céramique isolante électrique 76 entre deux plaques métalliques 76a, 76b, fabriqué à l'aide de différentes techniques (Direct Bonded Copper -DBC-, Active Metal Brazing -AMB-, Direct Bonded Aluminum -DBA-) et permettant de réaliser les interconnections (semi-conducteurs entre eux et avec les circuits électriques extérieurs) sur les parties métalliques supérieures et le report sur une semelle par la partie métallique inférieure,
. un joint brasé 78 souvent utilisé comme seconde interface d'interconnexion pour reporter le substrat sur une semelle,
. un cadre métallique conducteur formant semelle 80, généralement en cuivre, en aluminium ou en composite aluminium - carbure de silicium, et qui a pour rôle d'étaler le flux thermique et d'assurer une connexion mécanique avec un système de refroidissement,
. un matériau d'interface thermique 82 qui permet de réduire la résistance thermique de contact entre la semelle et un système de refroidissement pour assurer une meilleure évacuation du flux thermique. Ce matériau d'interface thermique peut être rigide (brasure, joint fritté,..) ou plus généralement souple (graisse thermique, film élastomère silicone, matériaux à changement de phases,...),
. un système de refroidissement 84, typiquement un radiateur à ailettes à refroidissement par air, mais un système à refroidissement liquide est aussi envisageable,
. des fils métalliques 86 assurant la connectique interne entre les différents composants et des connecteurs 88 (connectique externe) attachés (par des brasures 90) sur les plaques métalliques 76a des substrats pour assurer les contacts électriques avec les circuits électriques extérieurs, et
. enfin un boitier 92 servant de protection mécanique dans le cas d'un boitier en plastique ou de barrière de diffusion et de blindage électromagnétique dans le cas d'un boitier métallique, le vide dans le boitier étant rempli par un isolant encapsulant de type gel silicone 94.

Toutefois, cet empilement de matériaux présente plusieurs limitations notamment pour les applications à haute température (> 175°C) : la première est la forte résistance thermique (conductivité thermique faible de l'ordre de 2W/mK) initialement due au matériau d'interface thermique (dans le cas de matériau souple) et aux neuf couches de matériaux existant entre le semi-conducteur de puissance et le fluide de refroidissement (l'air au contact des ailettes du radiateur dans le cas d'un refroidissement par air), la seconde est liée à une instabilité à haute température, limitée initialement par la température de fonctionnement de l'interface thermique (graisse thermique : 150 °C) incompatible avec une utilisation aux hautes températures, et la dernière est une fiabilité limitée de l'assemblage due au phénomène de fatigue thermique résultant de la différence entre les coefficients de dilatations thermiques des divers matériaux. Plus particulièrement, dans le cas d'utilisation de matériaux d'interface thermique rigide (cas du brasage ou du frittage), cette fatigue est une source de propagation de fissure dans la brasure sur les surfaces larges notamment entre le substrat et la semelle et entre la semelle et le radiateur. En effet, le procédé pour assurer une bonne interface reste complexe et les contraintes mécaniques sont très élevées limitant ainsi sa fiabilité thermomécanique.

Les documents US 2011/286179 A1, US 2008/024995 A1 et EP 0 954 210 A1 décrivent des exemples de l'art antérieur pertinents.

### Exposé de l'invention

La présente invention a pour objet de pallier les inconvénients précités en proposant un module électronique de puissance nécessitant un nombre réduit d'étapes de fabrication par rapport aux modules conventionnels et qui pour cela comporte un cadre métallique tridimensionnel usiné d'un seul tenant et intégrant au moins le refroidisseur et les connexions aux circuits électriques extérieurs.

Ces buts sont atteints par un cadre métallique conducteur pour module électronique de puissance comprenant au moins des premier et second composants semi-conducteurs de puissance ayant chacun des faces supérieure et inférieure, des connecteurs pour relier ces composants semi-conducteurs de puissance à des circuits électriques extérieurs et au moins un radiateur pour évacuer via le cadre métallique conducteur le flux thermique généré par les composants semi-conducteurs de puissance, le cadre métallique conducteur étant caractérisé en ce que les connecteurs, le au moins un radiateur et le cadre métallique conducteur forme une unique pièce tridimensionnelle d'un seul matériau sur une surface intérieure de laquelle sont destinés à être fixés par leur faces inférieures les premier et second composants semi-conducteurs de puissance et en ce qu'il comporte en outre une ligne de pliage centrale pour une fois le cadre métallique conducteur replié sur lui-même en enfermant les premier et second composants semi-conducteurs de puissance, il assure un assemblage à refroidissement double face.

Ainsi, en supprimant la céramique métallisée, les différents polymères constituants les joints adhésifs pour coller le boitier, le matériau d'interface thermique et le boitier lui-même, une utilisation du module de puissance pour des températures supérieures à 200 °C devient possible sous réserve de choisir un encapsulant qui peut tenir les températures recherchées.

De préférence, le cadre métallique conducteur peut intégrer également un peigne métallique à ailettes interdigitées destiné à former un condensateur de découplage une fois le cadre métallique conducteur replié sur lui-même ou une ou plusieurs lames métalliques de section déterminée destinée à former un shunt de courant.

Avantageusement, il comporte des plots de centrage destinés à être reçus dans des orifices de centrage une fois le cadre métallique conducteur replié sur lui-même.

De préférence, il est aminci au niveau de la ligne de pliage centrale.

Avantageusement, le matériau du cadre métallique conducteur est choisi parmi les matériaux suivants : aluminium, cuivre ou or.

L'invention concerne également le module électronique de puissance comportant un cadre métallique conducteur tel que précité.

L'invention concerne encore un procédé de fabrication d'un module électronique de puissance comprenant au moins des premier et second composants semi-conducteurs de puissance ayant chacun des faces supérieure et inférieure, des connecteurs pour relier ces composants semi-conducteurs de puissance à des circuits électriques extérieurs et au moins un radiateur pour évacuer via un cadre métallique conducteur le flux thermique généré par les composants semi-conducteurs de puissance, caractérisé en ce qu'il comporte les étapes suivantes :.fabrication d'un cadre métallique conducteur tridimensionnel présentant une ligne de pliage centrale et comportant plusieurs structures géométriques comportant chacune une fonction déterminée, dépôt d'un joint d'attache sur des espaces déterminés d'une surface intérieure du cadre métallique conducteur tridimensionnel sur laquelle sont destinés à être fixés les premier et second composants semi-conducteurs de puissance, fixation des faces inférieures des premier et second composants semi-conducteurs de puissance sur une partie des espaces déterminés de la surface intérieure du cadre métallique conducteur tridimensionnel, pliage en deux parties selon la ligne de pliage centrale du cadre métallique conducteur tridimensionnel et fixation des faces supérieures des premier et second composants semi-conducteurs de puissance sur une autre partie des espaces déterminés de la surface intérieure du cadre métallique conducteur tridimensionnel, de sorte à assurer un assemblage à refroidissement double face, solidification du joint d'attache et moulage dans un encapsulant formé d'un matériau isolant électriquement, et découpe de parties du cadre métallique conducteur tridimensionnel qui ne participent à aucune fonction électrique, thermique ou mécanique pour obtenir le module électronique de puissance.

Avantageusement, le cadre métallique conducteur tridimensionnel est obtenu par usinage mécanique ou impression 3D métallique.

De préférence, l'étape de dépôt du joint d'attache est précédée d'une étape de métallisation de la surface intérieure du cadre métallique conducteur tridimensionnel.

### Brève description des dessins

D'autres caractéristiques et avantages de la présente invention ressortiront mieux de la description faite ci-dessous, en référence aux dessins annexés qui en illustrent des exemples de réalisation non limitatifs et sur lesquels :
[Fig. 1A] La figure 1A est une vue en perspective de dessus d'un premier exemple de réalisation d'un cadre métallique conducteur selon l'invention,
[Fig. 1B] La figure 1B est une vue en perspective de dessous d'un premier exemple de réalisation d'un cadre métallique conducteur selon l'invention,
[Fig. 2A] La figure 2A montre une étape de fabrication d'un module de puissance comportant le cadre métallique conducteur des figures 1A et 1B,
[Fig. 2B] La figure 2B montre une étape de fabrication d'un module de puissance comportant le cadre métallique conducteur des figures 1A et 1B,
[Fig. 2C] La figure 2C montre une étape de fabrication d'un module de puissance comportant le cadre métallique conducteur des figures 1A et 1B,
[Fig. 2D] La figure 2D montre une étape de fabrication d'un module de puissance comportant le cadre métallique conducteur des figures 1A et 1B,
[Fig. 2E] La figure 2E montre une étape de fabrication d'un module de puissance comportant le cadre métallique conducteur des figures 1A et 1B,
[Fig. 2F] La figure 2F montre une étape de fabrication d'un module de puissance comportant le cadre métallique conducteur des figures 1A et 1B,
[Fig. 3] La figure 3 montre avant encapsulation l'intégration d'un condensateur de découplage sur le cadre métallique conducteur de l'invention,
[Fig. 4] La figure 4 montre avant encapsulation l'intégration d'un shunt de courant sur le cadre métallique conducteur de l'invention,
[Fig. 5] La figure 5 est une vue de dessous en perspective d'un second exemple de réalisation d'un cadre métallique conducteur selon l'invention,
[Fig. 6A] La figure 6A montre une étape de fabrication d'un module de puissance comportant le cadre métallique conducteur de la figure 5,
[Fig. 6B] La figure 6B montre une étape de fabrication d'un module de puissance comportant le cadre métallique conducteur de la figure 5,
[Fig. 6C] La figure 6C montre une étape de fabrication d'un module de puissance comportant le cadre métallique conducteur de la figure 5,
[Fig. 6D] La figure 6D montre une étape de fabrication d'un module de puissance comportant le cadre métallique conducteur de la figure 5,
[Fig. 6E] La figure 6E montre une étape de fabrication d'un module de puissance comportant le cadre métallique conducteur de la figure 5,
[Fig. 6F] La figure 6F montre une étape de fabrication d'un module de puissance comportant le cadre métallique conducteur de la figure 5,
[Fig. 6G] La figure 6G montre une étape de fabrication d'un module de puissance comportant le cadre métallique conducteur de la figure 5,
[Fig. 7] La figure 7 montre un module de puissance à semi-conducteurs conventionnel à un étage comportant deux transistors de type MOSFET, et
[Fig. 8] La figure 8 illustre en coupe et de façon schématique la superposition de couches des différents matériaux formant un module de puissance à semi-conducteurs conventionnel.

### Description des modes de réalisation

La présente invention a pour objet un cadre métallique conducteur tridimensionnel dont une face supérieure (ou extérieure) intègre au moins un radiateur et des connecteurs de liaison à des circuits externes, les composants à semi-conducteurs de puissance étant attachés classiquement par brasage ou frittage au moyen de joint d'attache sur une face inférieure (ou intérieure) de ce cadre et l'assemblage ainsi formé est protégé dans un matériau encapsulant.

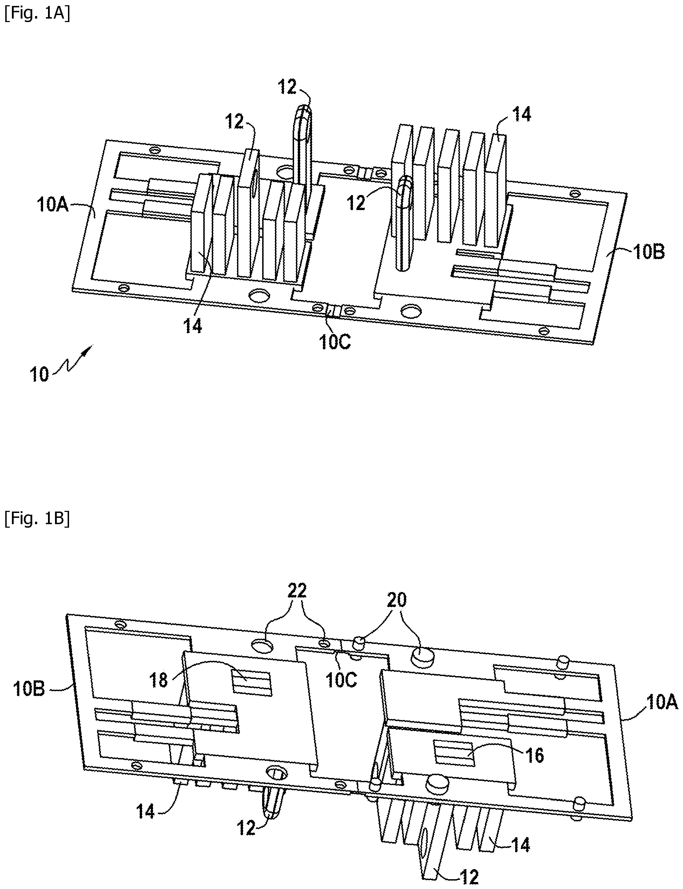

Les figures 1A et 1B montrent par une vue en perspective respectivement de dessus et de dessous ce cadre métallique conducteur 10 qui forme avec les connecteurs de liaison 12 et les deux radiateurs 14 montés sur sa face supérieure une pièce monobloc d'un seul matériau sur la face inférieure de laquelle sont fixés au moyen d'un joint d'attache les premier 16 et second 18 composants semi-conducteurs de puissance. Ce cadre métallique conducteur est donc un objet tridimensionnel qui s'étend verticalement depuis une base rectangulaire séparée en deux parties quasi-symétriques 10A, 10B supportant chacune un radiateur 14 et au moins un connecteur de liaison 12, la partie 10C du cadre métallique conducteur assurant la jonction entre ces deux parties étant amincie pour former une ligne de pliage centrale de ce cadre métallique conducteur. Le radiateur est avantageusement un radiateur à ailettes à refroidissement par air mais un refroidisseur à eau pourvu de canaux ou micro-canaux est aussi envisageable ou bien encore toute autre forme géométrique plus complexe.

La base du cadre métallique conducteur comporte de préférence à sa périphérie et sur une des deux parties (par exemple 10A) des plots de centrage 20 destinés à être reçus dans des orifices de centrage 22 disposés sur l'autre des deux parties (en l'espèce 10B), une fois le cadre métallique conducteur replié sur lui-même, comme il sera expliqué plus avant.

Le cadre métallique conducteur peut être réalisé avantageusement par tout procédé connu de fabrication additive métallique, par exemple de type SLM (pour « Selective Laser Melting »), dans un même matériau conducteur tel que l'aluminium, le cuivre ou un composite aluminium - carbure de silicium par exemple, soit encore par un usinage mécanique d'un bloc de matériau brut.

Cette réalisation mono-matériau limite les contraintes mécaniques résiduelles et réduit le temps d'assemblage et de réalisation du module de puissance, comme il sera décrit plus avant. Les radiateurs peuvent ainsi présenter une géométrie complexe et une masse réduite ce qui permet d'augmenter la densité de puissance massique des convertisseurs.

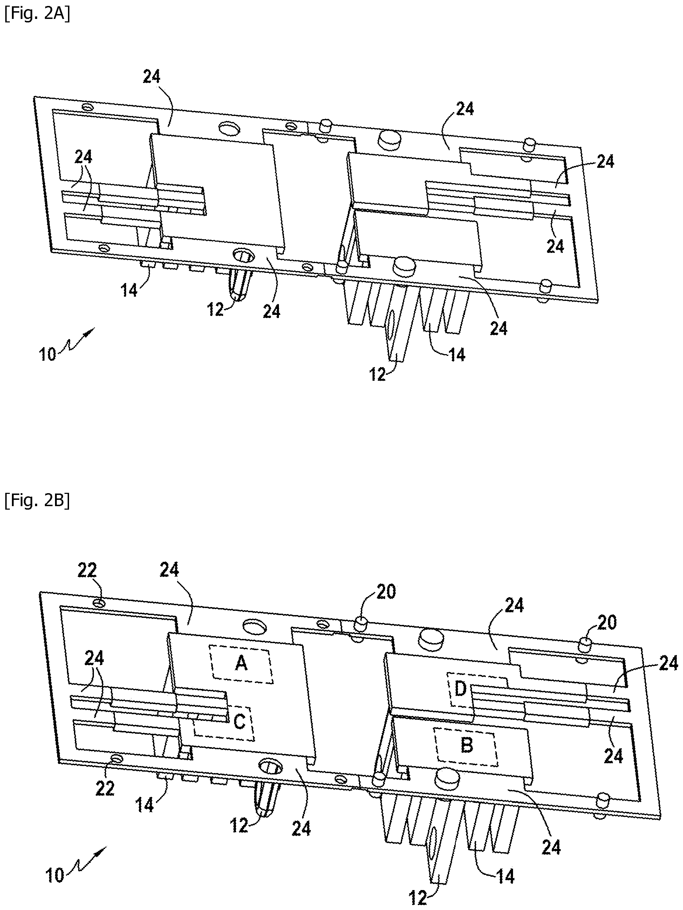

Les figures 2A à 2F montrent les différentes étapes de fabrication d'un module de puissance comportant le cadre métallique conducteur précité. Ce procédé ne met en oeuvre que quatre matériaux qui présentent avantageusement des coefficients de dilatation thermique équivalent : le métal du cadre métallique conducteur (AI, Cu, etc.), le matériau des composants semi-conducteurs (ou puces) de puissance (Si, SiC, etc.), le joint d'attache (obtenu par brasage SnAgCu, etc. ou frittage Ag, Cu, etc.) et le matériau encapsulant l'assemblage ainsi formé.

La première étape (figure 2A) consiste en un usinage mécanique ou une impression 3D métallique par un procédé de fabrication additive du cadre métallique conducteur 10. Comme il a été mentionné précédemment, ce cadre comporte plusieurs structures géométriques correspondant chacune à une fonction bien spécifique (radiateurs 14, connecteurs 12 et possibles autres composants passifs comme il sera décrit plus avant). Ces structures tridimensionnelles, associées à des fonctions spécifiques, sont donc faites d'un même matériau et reliées entre elles ou à la périphérie du cadre métallique conducteur par des ponts 24 qui seront coupés à la fin du procédé.

La deuxième étape (figure 2B) consiste à réaliser sur la base inférieure du cadre métallique conducteur 10 le joint d'attache (brasure, joint fritté, colle à charges métalliques, etc.) qui assurera la fixation des composants semi-conducteurs de puissance à des positions prédéterminées (zones A, B, C et D) du cadre métallique conducteur, par exemple avec un écran de sérigraphie ou bien un outillage automatique (de type machine Pick & place). Dans l'un ou l'autre cas, les plots 20 ou les orifices 22 permettrons de définir des repères de centrage pour la machine ou l'écran de sérigraphie (tous deux non illustrés).

On notera que cette deuxième étape peut être précédée d'une étape de métallisation (Ni/Au par exemple) des zones destinés à recevoir les composants semi-conducteurs de puissance pour faciliter la fixation de ces composants.

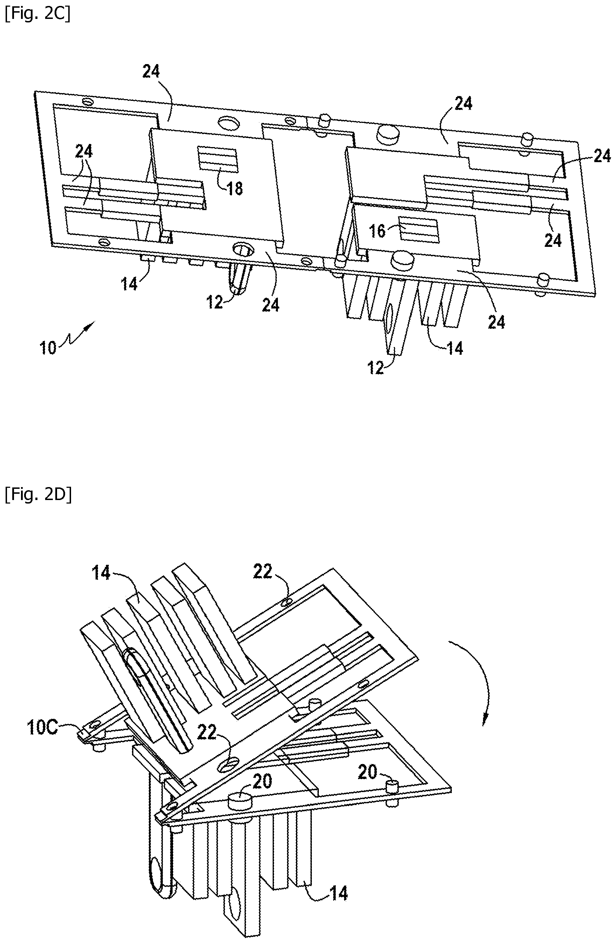

La troisième étape (figure 2C) consiste à positionner la face inférieure des composants semi-conducteurs de puissance 16, 18 au-dessus des joints d'attache correspondants des zones A et B avec un outillage mécanique ou bien une machine automatique (également de type Pick & Place). On notera que lorsque le composant semi-conducteur de puissance est un transistor MOSFET, la face du MOSFET positionnée sur le joint d'attache correspond au drain du transistor, la source et la grille étant sur la face supérieure du composant laissée libre dans cette étape.

Dans une quatrième étape (figure 2D), le cadre métallique conducteur est plié sur lui-même (avec précision en glissant les plots 20 dans les orifices 22) au niveau de sa ligne de pliage 10C afin de venir se positionner au-dessus des composants semi-conducteurs de puissance. Cette action de pliage permet grâce au joint d'attache pré-déposé dans les zones C et D à la deuxième étape d'assurer l'attache de la face supérieure des composants semi-conducteurs de puissance et ainsi d'avoir un assemblage avec un radiateur sur les deux faces, c'est-à-dire un refroidissement double face. Lorsque le composant semi-conducteur de puissance est un transistor MOSFET, c'est la face du MOSFET correspondant à la source et à la grille laissée libre dans l'étape précédente qui est maintenant positionnée sur le joint d'attache. Le pliage assure aussi si besoin la connexion des connecteurs.

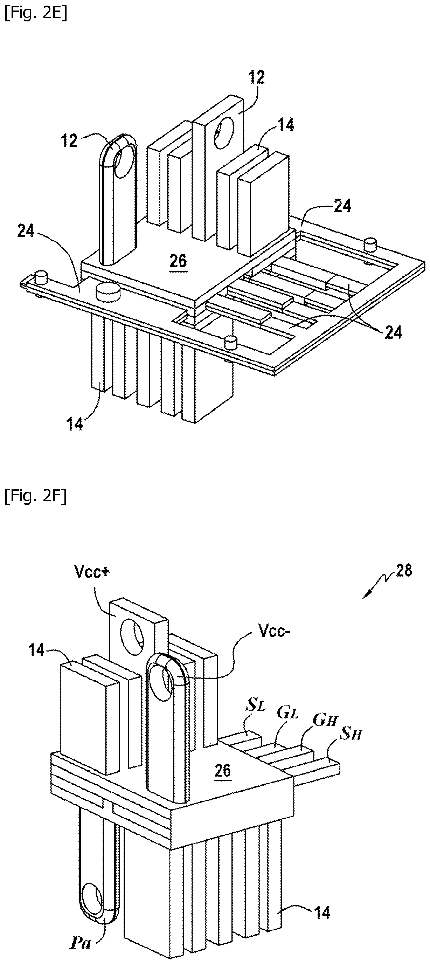

Dans une cinquième étape (figure 2E) et selon la nature de joint d'attache, l'assemblage est solidifié à haute température afin de pouvoir réaliser le frittage soit mis dans un four afin de solidifier la brasure, puis il est moulé partiellement dans un encapsulant dur 26 (ou un isolant électrique de type Parylène par exemple) afin de protéger les composants semi-conducteurs de l'environnement extérieur et de réduire les phénomènes de décharges partielles dans l'air.

Enfin dans une dernière étape (figure 2F), les parties de ponts 24 (voir la figure précédente) du cadre métallique conducteur qui servent à retenir les diverses structures géométriques à la base du cadre, mais qui n'ont aucune fonction électrique, ni thermique ni mécanique, sont découpées pour former le module de puissance désiré 28 qui présente donc un refroidissement sur ces deux faces et les connexions et liaisons classiques à des circuits électriques extérieurs d'un tel module de puissance, à savoir : les bornes Vcc+ et Vcc-, les deux bornes de source et de grille des deux transistors Sh, Gh et SI, Gl et la borne de phase Pa du module.

Comme indiqué précédemment, les structures géométriques peuvent être diverses et comporter également des composants passifs.

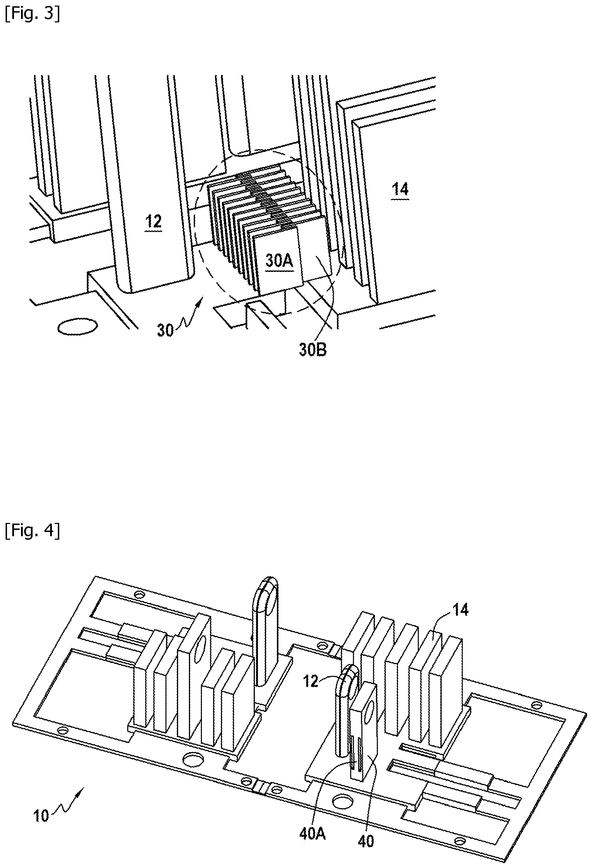

La figure 3 montre un premier exemple d'intégration d'un composant passif sur le cadre métallique conducteur. En effet, avec la structure monobloc de l'invention, il est possible d'ajouter un condensateur de découplage entre les bornes d'alimentation électriques Vcc+ et Vcc-, au plus près des composants semi-conducteurs de puissance. Cela permet de réduire l'effet des inductances de boucle parasites, constitue une réserve d'énergie suffisante pour alimenter la charge, supprime les harmoniques de hautes fréquences vers le plus faible potentiel électrique et augmente donc l'immunité électromagnétique du circuit. Plus précisément, ce condensateur de filtrage est réalisé sous forme d'un peigne métallique 30 avec des ailettes interdigitées 30A, 30B en alternance sur une partie du cadre au potentiel Vcc+ et sur une autre partie du cadre au potentiel Vcc-. La fonction capacité de ce condensateur sera obtenue en ajoutant entre les ailettes formant les armatures de ce condensateur un matériau diélectrique qui peut être le matériau d'encapsulation défini précédemment ou un autre type de matériau.

De même, la figure 4 montre un second d'exemple possible d'intégration d'un composant passif, en l'espèce un shunt de courant 40 (une simple résistance électrique de très faible valeur qui permet de mesurer le courant électrique la traversant) réalisé sous forme d'une ou plusieurs lames métalliques 40A de section déterminée. La géométrie particulière de ce shunt de courant permettra de lui donner une valeur de résistance connue avec précision.

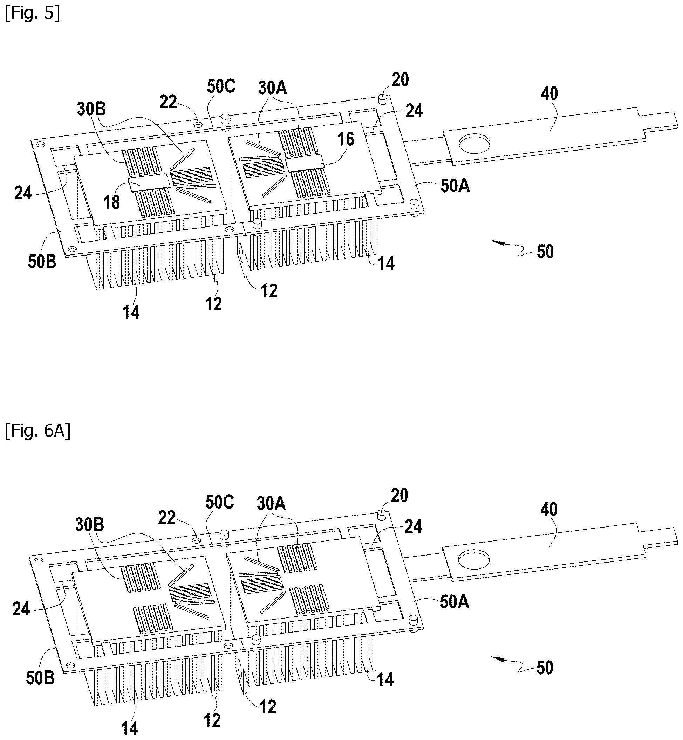

La figure 5 est une vue en perspective de dessous d'un second exemple de réalisation d'un cadre métallique conducteur 50 selon l'invention. On retrouve un cadre métallique conducteur avec deux parties symétriques 50A, 50B séparées par une ligne centrale de pliage 50C, ces deux parties étant inscrites dans un cadre périphérique portant pour l'une (par exemple la zone 50A) des plots de centrage 20 et pour l'autre des orifices de centrage 22 (en l'espèce 50B), ces plots étant destinés à être reçus dans ces orifices une fois le cadre métallique conducteur replié sur lui-même. Chacune de ces deux parties supporte sur sa face extérieure un radiateur 14 et un connecteur 12 et sur sa face intérieure une des deux armatures 30A, 30B d'un condensateur de filtrage 30, ces différents éléments étant reliés à la périphérie du cadre métallique conducteur par des ponts de liaison 24. Ces deux armatures sont ici formées d'une pluralité d'ailettes réparties autour des espaces destinés à recevoir le premier 16 et le second 18 composants semi-conducteurs de puissance. Enfin, un shunt de courant 40 formé d'une lame ou languette métallique de section déterminée et réalisé avec les autres structures géométriques (radiateurs, connecteurs et condensateur) en un même matériau par un procédé de fabrication additive ou un usinage mécanique, s'étend vers l'extérieur du cadre métallique conducteur depuis l'une ses deux parties (en l'espèce la partie 50A).

Les figures 6A à 6G montrent les différentes étapes de fabrication d'un module de puissance comportant le cadre métallique conducteur de ce second exemple de réalisation.

La première étape (figure 6A) consiste en la fabrication du cadre métallique conducteur regroupant maintenant quatre types de structures géométriques : des radiateurs, des connecteurs, un condensateur et un shunt. Le condensateur est disposé sur la face intérieure du cadre métallique conducteur, les radiateurs (liquide ou air en l'espèce) et les connecteurs sur la face extérieure, le shunt de courant prolongeant le cadre présentant à la fois une face interne et une face externe.

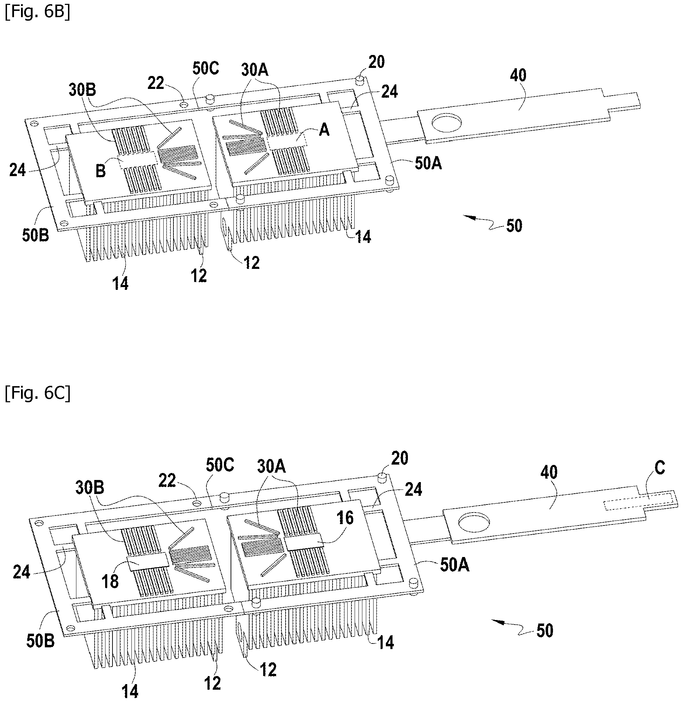

La deuxième étape (figure 6B) consiste à réaliser le joint d'attache (brasure, joint fritté ou colle chargée) qui assurera la fixation des composants semi-conducteurs de puissance à une position prédéterminée (zones A et B) du cadre métallique conducteur. Toutefois, dans le présent mode de réalisation, les ailettes du condensateur étant disposé tout autour du composant semi-conducteur de puissance empêchent de déposer ce joint d'attache avec un écran de sérigraphie, le recours à un outillage automatique est seul envisageable avec cette configuration.

La troisième étape (figure 6C) consiste comme précédemment à positionner la face inférieure des composants semi-conducteurs de puissance au-dessus des joints d'attache avec un outillage mécanique ou bien une machine automatique de précision.

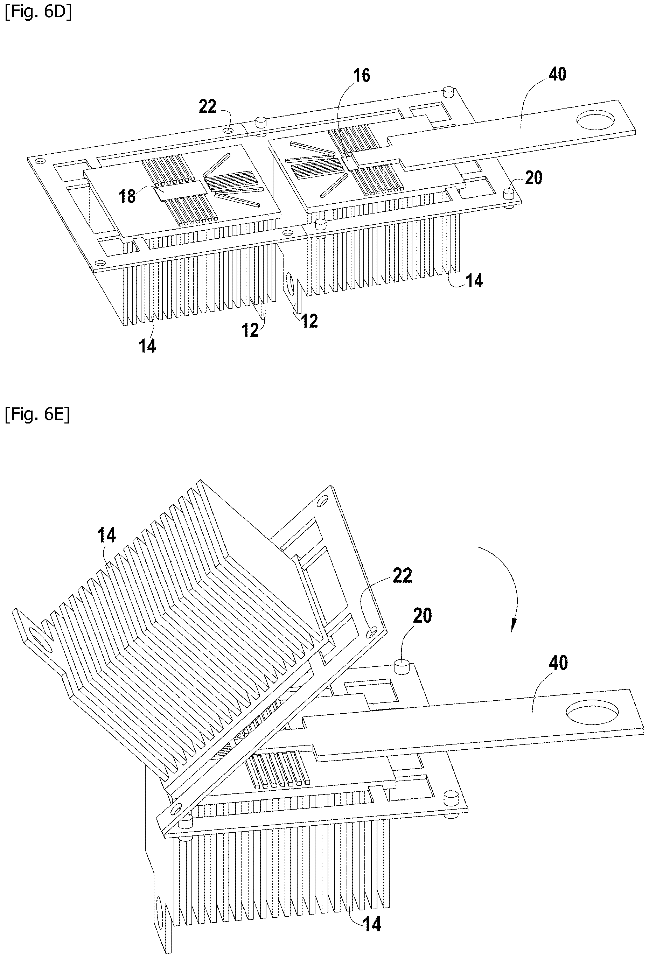

Dans une quatrième étape (figure 6C), un autre joint d'attache est déposé sur la languette métallique 40 à la fois sur sa face supérieure (zone C) et sur sa face inférieure (la face cachée) avant que cette languette métallique ne soit repliée pour la positionner au-dessus de l'un des deux composants semi-conducteurs de puissance dans une cinquième étape (figure 6D).

Le cadre métallique conducteur est alors à son tour, dans une sixième étape (figure 6E), plié sur lui-même avec précision (par la coopération des plots 20 avec les orifices 22 correspondant) afin d'assurer l'attache de la face supérieure des composants semi-conducteurs de puissance et d'avoir un assemblage à refroidissement double face. Dans cette configuration, chaque composant semi-conducteur de puissance se trouve ainsi pris en sandwich entre deux joints d'attache, dont l'un est en contact avec la languette métallique 40.

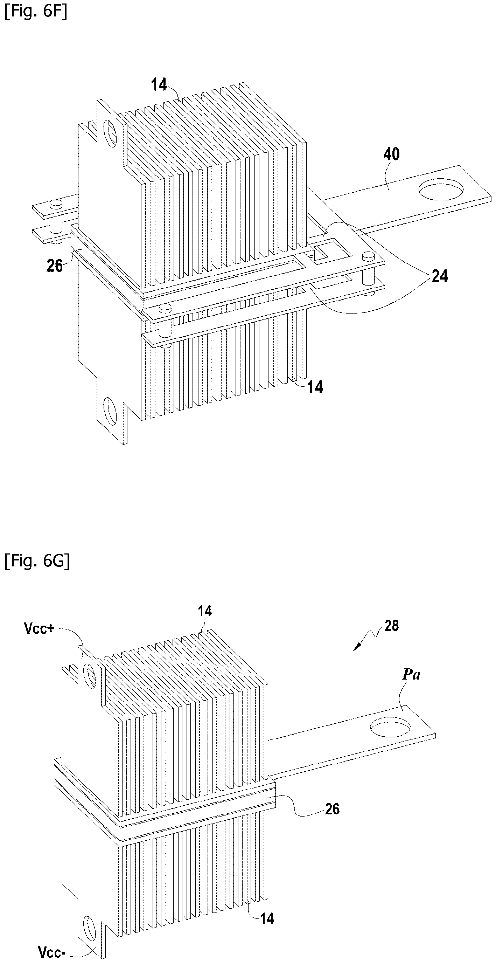

Dans une septième étape (figure 6F) le joint d'attache est solidifié à haute température ou chauffage selon sa nature.

Le dépôt d'une matière isolante électriquement 26 (type encapsulant dur, Parylène, etc.) sur une partie de l'assemblage ainsi réalisé dans une huitième étape (figure 6F) permet de compléter l'isolation électrique et de matérialiser la capacité entre les deux armatures du condensateur que le pliage a interdigité.

Enfin une dernière étape (figure 6G) consiste en la découpe de la partie du cadre métallique conducteur (voir les ponts 24 à la figure précédente) qui a servi à retenir les diverses structures géométriques mais n'ayant ni fonction électrique, ni thermique, ni mécanique, est devenu inutile, pour obtenir le module de puissance désiré 28 qui présente donc un refroidissement sur ces deux faces et les connexions et liaisons classiques à des circuits externes d'un tel module de puissance, à savoir : les bornes d'alimentation Vcc+ et Vcc- et la borne de phase Pa (pour des raisons de simplification les bornes de source et de grille qui sortiront dans le même plan que la borne de phase Pa et du même côté que Vcc+ et Vcc-, ne sont pas représentées). En tout état de cause, les entrées sont disponibles sur un côté du module et la sortie sur un autre côté du module.

On notera que dans l'un ou l'autre de ces deux modes de réalisation précités, afin de véhiculer le signal (faible courant, faible tension) vers les composants semi-conducteurs de puissance, il est possible de déposer une fine couche conductrice sur une isolation électrique formée par un dépôt d'un isolant électrique (type parylène par exemple) sur la face intérieure du cadre métallique conducteur. Cette technique est classiquement utilisée lors de la fabrication de circuit imprimé (PCB) en technologie Substrat Métallique Isolé (SMI).

On notera également que, si dans le cadre d'applications spécifiques, on est amené à recourir à des composants semi-conducteurs de puissance d'épaisseurs différentes, l'usinage monobloc ou la fabrication additive permettra facilement de compenser ce jeu d'épaisseur.

Comparativement à l'art antérieur, le procédé de l'invention permet de générer en une seule étape l'ensemble des composants passifs constitutifs d'un module de puissance auxquels il faut classiquement rattacher les éléments actifs de puissance grâce à des joints d'attache, réduisant alors le nombre d'étapes de fabrication, améliorant l'interface de dissipation thermique et augmentant la fiabilité via la réduction du nombre d'interfaces potentiellement sujettes à rupture thermomécanique.

Avec l'invention, le nombre de matériaux et d'interfaces utilisés est réduit, notamment le substrat céramique métallisé, le matériau d'interface thermique et les attaches des connectiques et des boitiers sont supprimés, menant ainsi à une réduction du poids et du volume du module électronique de puissance. Cela permet une amélioration de la fiabilité de l'assemblage et une réduction de sa résistance thermique. De plus, la réalisation de radiateurs localisés sur le cadre métallique conducteur en vis-à-vis des points chauds (les composants semi-conducteurs de puissance) permet une gestion efficace de la thermique.

Ainsi, un module de puissance à base d'un cadre métallique conducteur tridimensionnel conforme à l'invention permet d'une part de réaliser un assemblage complexe avec diverses fonctions: capteurs de courant, connexions externes, système de refroidissement (liquide, air, etc.), condensateur de découplage sur le bus DC ou bien à proximité du composant semi-conducteur de puissance, etc..., et d'autre part d'obtenir un assemblage à faibles contraintes résiduelles du fait de la présence de seulement deux profils thermiques lors de l'assemblage, à savoir : l'attache de puces (par brasage ou frittage) et l'encapsulation qui sera de préférence réalisée sous vide.

## Revendications

1. Cadre métallique conducteur (10, 50) pour module électronique de puissance comprenant au moins des premier (16) et second (18) composants semi-conducteurs de puissance ayant chacun des faces supérieure et inférieure, des connecteurs (12) pour relier ces composants semi-conducteurs de puissance à des circuits électriques extérieurs et au moins un radiateur (14) pour évacuer via le cadre métallique conducteur le flux thermique généré par les composants semi-conducteurs de puissance, le cadre métallique conducteur étant **caractérisé en ce que** les connecteurs, le au moins un radiateur et le cadre métallique conducteur forment une unique pièce tridimensionnelle d'un seul matériau sur une surface intérieure de laquelle sont destinés à être fixés par leur faces inférieures les premier et second composants semi-conducteurs de puissance et **en ce qu'**il comporte en outre une ligne de pliage centrale (50C) qui une fois le cadre métallique conducteur replié sur lui-même en enfermant les premier et second composants semi-conducteurs de puissance, assure un assemblage à refroidissement double face.

2. Cadre métallique conducteur selon la revendication 1, **caractérisé en ce qu'**il intègre également un peigne métallique (30) à ailettes interdigitées (30A, 30B) destiné à former un condensateur de filtrage une fois le cadre métallique conducteur replié sur lui-même.

3. Cadre métallique conducteur selon la revendication 1, **caractérisé en ce qu'**il intègre également une ou plusieurs lames métalliques (40A) de section déterminée destinée à former un shunt de courant.

4. Cadre métallique conducteur selon la revendication 1, **caractérisé en ce qu'**il comporte des plots de centrage (20) destinés à être reçus dans des orifices de centrage (22) une fois le cadre métallique conducteur replié sur lui-même,

5. Cadre métallique conducteur selon l'une quelconque des revendications 1 à 4, **caractérisé en ce qu'**il est aminci au niveau de la ligne de pliage centrale (50C).

6. Cadre métallique conducteur selon l'une quelconque des revendications 1 à 5, **caractérisé en ce que** le matériau du cadre métallique conducteur est choisi parmi les matériaux suivants : aluminium, cuivre ou or.

7. Module électronique de puissance (28) comportant un cadre métallique conducteur selon l'une quelconque des revendications 1 à 6.

8. Procédé de fabrication d'un module électronique de puissance (28) comprenant au moins des premier (16) et second (18) composants semi-conducteurs de puissance ayant chacun des faces supérieure et inférieure, des connecteurs (12) pour relier ces composants semi-conducteurs de puissance à des circuits électriques extérieurs et au moins un radiateur (14) pour évacuer via un cadre métallique conducteur (10, 50) le flux thermique généré par les composants semi-conducteurs de puissance, **caractérisé en ce qu'**il comporte les étapes suivantes: fabrication d'un cadre métallique conducteur tridimensionnel présentant une ligne de pliage centrale (50C) et comportant plusieurs structures géométriques comportant chacune une fonction déterminée, dépôt d'un joint d'attache sur des espaces déterminés d'une surface intérieure du cadre métallique conducteur tridimensionnel sur laquelle sont destinés à être fixés les premier et second composants semi-conducteurs de puissance, fixation des faces inférieures des premier et second composants semi-conducteurs de puissance sur une partie des espaces déterminés de la surface intérieure du cadre métallique conducteur tridimensionnel, pliage en deux parties selon la ligne de pliage centrale du cadre métallique conducteur tridimensionnel et fixation des faces supérieures des premier et second composants semi-conducteurs de puissance sur une autre partie des espaces déterminés de la surface intérieure du cadre métallique conducteur tridimensionnel, de sorte à assurer un assemblage à refroidissement double face, solidification du joint d'attache et moulage dans un encapsulant formé d'un matériau isolant électriquement, et découpe de parties du cadre métallique conducteur tridimensionnel qui ne participent à aucune fonction électrique, thermique ou mécanique pour obtenir le module électronique de puissance.

9. Procédé selon la revendication 8 **caractérisé en ce que** le cadre métallique conducteur tridimensionnel est obtenu par usinage mécanique ou impression 3D métallique.

10. Procédé selon la revendication 8 ou la revendication 9 **caractérisé en ce que** l'étape de dépôt du joint d'attache est précédée d'une étape de métallisation de la surface intérieure du cadre métallique conducteur tridimensionnel. :

## Patentansprüche

1. Leitender Metallrahmen (10, 50) für ein elektronisches Leistungsmodul, umfassend zumindest eine erste (16) und zweite (18) Halbleiter-Leistungskomponente, die jeweils obere und untere Seitenflächen aufweisen, Verbinder (12) zum Verbinden dieser Halbleiter-Leistungskomponenten mit externen elektrischen Kreisen und zumindest einen Kühlkörper (14) zum Abführen des durch die Halbleiter-Leistungskomponenten erzeugten thermischen Flusses über den leitenden Metallrahmen, wobei der leitende Metallrahmen **dadurch gekennzeichnet ist, dass** die Verbinder, der zumindest eine Kühlkörper und der leitende Metallrahmen ein einziges dreidimensionales Teil aus einem einzigen Material bilden, an dessen innerer Oberfläche die erste und zweite Halbleiter-Leistungskomponente mit ihren unteren Seitenflächen befestigt werden sollen, und dass er ferner eine zentrale Faltungslinie (50C) beinhaltet, die, sobald der leitende Metallrahmen auf sich selbst zurückgefaltet ist und dabei die erste und zweite Halbleiter-Leistungskomponente umschließt, eine doppelseitige Kühlanordnung sicherstellt.

2. Leitender Metallrahmen nach Anspruch 1, **dadurch gekennzeichnet, dass** er auch einen Metallkamm (30) mit ineinandergreifenden Lamellen (30A, 30B) integriert hat, der dazu bestimmt ist, einen Filter-Kondensator zu bilden, sobald der leitende Metallrahmen auf sich selbst zurückgefaltet ist.

3. Leitender Metallrahmen nach Anspruch 1, **dadurch gekennzeichnet, dass** er auch ein oder mehrere Metallplättchen (40A) mit bestimmtem Querschnitt integriert hat, der dazu bestimmt ist, einen Strom-Nebenschluss zu bilden.

4. Leitender Metallrahmen nach Anspruch 1, **dadurch gekennzeichnet, dass** er Zentrierstifte (20) beinhaltet, die dazu bestimmt sind, in Zentrieröffnungen (22) aufgenommen zu werden, sobald der leitende Metallrahmen auf sich selbst zurückgefaltet ist.

5. Leitender Metallrahmen nach einem der Ansprüche 1 bis 4, **dadurch gekennzeichnet, dass** er auf Höhe der zentralen Faltungslinie (50C) verjüngt ist.

6. Leitender Metallrahmen nach einem der Ansprüche 1 bis 5, **dadurch gekennzeichnet, dass** das Material des leitenden Metallrahmens unter den folgenden Materialien ausgewählt ist: Aluminium, Kupfer oder Gold.

7. Elektronisches Leistungsmodul (28), das einen leitenden Metallrahmen nach einem der Ansprüche 1 bis 6 beinhaltet.

8. Verfahren zur Herstellung eines elektronischen Leistungsmoduls (28), das zumindest eine erste (15) und zweite (18) Halbleiter-Leistungskomponente, die jeweils obere und untere Seitenflächen aufweisen, Verbinder (12) zum Verbinden dieser Halbleiter-Leistungskomponenten mit externen elektrischen Kreisen, und zumindest einen Kühlkörper (14) zum Abführen des durch die Halbleiter-Leistungskomponenten erzeugten thermischen Flusses über einen leitenden Metallrahmen (10, 50) umfasst, **dadurch gekennzeichnet, dass** es die folgenden Schritte beinhaltet: Herstellung eines dreidimensionalen leitenden Metallrahmens, der eine zentrale Faltungslinie (50C) aufweist und mehrere geometrische Strukturen beinhaltet, die jeweils eine bestimmte Funktion beinhalten, Aufbringen einer Anschlussverbindung auf bestimmte Räume einer Innenfläche des dreidimensionalen leitenden Metallrahmens, an welcher die erste und zweite Halbleiter-Leistungskomponente befestigt werden sollen, Befestigung der unteren Seitenflächen der ersten und zweiten Halbleiter-Leistungskomponente an einem Teil der bestimmten Räume der inneren Oberfläche des dreidimensionalen leitenden Metallrahmens, Faltung des leitenden Metallrahmens in zwei Teile entlang der zentralen Faltungslinie, und Befestigung der oberen Seitenflächen der ersten und zweiten Halbleiter-Leistungskomponente an einem anderen Teil der bestimmten Räume der inneren Oberfläche des dreidimensionalen leitenden Metallrahmens, sodass eine doppelseitige Kühlanordnung sichergestellt wird, Verfestigung der Anschlussverbindung und Einformung in eine Verkapselung, die aus einem elektrisch isolierenden Material gebildet ist, und Abschneiden der Teile des dreidimensionalen leitenden Metallrahmens, die zu keiner elektrischen, thermischen oder mechanischen Funktion beitragen, um so das elektronische Leistungsmodul zu erhalten.

9. Verfahren nach Anspruch 8, **dadurch gekennzeichnet, dass** der dreidimensionale leitende Metallrahmen durch mechanische Bearbeitung oder 3D-Metalldruck erhalten wird.

10. Verfahren nach Anspruch 8 oder Anspruch 9, **dadurch gekennzeichnet, dass** dem Schritt des Aufbringens der Anschlussverbindung ein Schritt der Metallisierung der inneren Oberfläche des dreidimensionalen leitenden Metallrahmens vorausgeht.

## Claims

1. A conductive metal frame (10, 50) for a power electronics module comprising at least first (16) and second (18) power semiconductor components each having upper and lower faces, connectors (12) for linking these power semiconductor components to external electrical circuits and at least one radiator (14) for expelling via the conductive metal frame the heat flow generated by the power semiconductor components, the conductive metal frame being **characterized in that** the connectors, the at least one radiator and the conductive metal frame form a single three-dimensional part made of a single material on an inner surface of which the first and second power semiconductor components are intended to be attached by their lower faces and **in that** it further includes a central folding line (50C) which, once the conductive metal frame is folded on itself, enclosing the first and second power semiconductor components, provides a double-sided cooling assembly.

2. The conductive metal frame as claimed in claim 1, **characterized in that** it also includes a metal comb (30) with interdigitated fins (30A, 30B) intended to form a filtering capacitor once the conductive metal frame is folded on itself.

3. The conductive metal frame as claimed in claim 1, **characterized in that** also includes one or more metal leaves (40A) of determined section intended to form a current shunt.

4. The conductive metal frame as claimed in claim 1, **characterized in that** it includes locating studs (20) intended to be housed in locating holes (22) once the conductive metal frame is folded on itself.

5. The conductive metal frame as claimed in any of claims 1 to 4, **characterized in that** it is thinned at the level of the central folding line (50C).

6. The conductive metal frame as claimed in any of claims 1 to 5, **characterized in that** the material of the conductive metal frame is chosen from among the following materials: aluminum, copper or gold.

7. A power electronics module (28) including a conductive metal frame as claimed in any of claims 1 to 6.

8. A process for manufacturing a power electronics module (28) comprising at least first (16) and second (18) power semiconductor components each having upper and lower faces, connectors (12) for linking these power semiconductor components to external electrical circuits and at least one radiator (14) for expelling via a conductive metal frame (10, 50) the heat flow generated by the power semiconductor components, **characterized in that** it includes the following steps: manufacturing a three-dimensional conductive metal frame having a central folding line (50C) and including several geometrical structures each including a predetermined function, depositing a seal on predetermined spaces of an inner surface of the three-dimensional conductive metal frame to which the first and second power semiconductor components are intended to be attached, attaching the lower faces of the first and second power semiconductor components to a part of the predetermined spaces of the inner surface of the three-dimensional conductive metal frame, folding the three-dimensional conductive metal frame into two parts along the central folding line and attaching the upper faces of the first and second power semiconductor components on another part of the predetermined spaces of the inner surface of the three-dimensional conductive metal frame, such as to provide a double-sided cooling assembly, solidifying the seal and molding in an encapsulant formed of an electrically insulating material, and cutting off parts of the three-dimensional conductive metal frame which do not contribute any electrical, thermal or mechanical function to obtain the power electronics module.

9. The process as claimed in claim 8, **characterized in that** the three-dimensional conductive metal frame is obtained by mechanical machining or metal 3D printing.

10. The process as claimed in claim 8 or claim 9, **characterized in that** the step of depositing the seal is preceded by a step of electrical bonding of the inner surface of the three-dimensional conductive metal frame.
